Europäisches Patentamt

European Patent Office

Office européen des brevets

(19)

(11) **EP 1 193 876 A1**

(12) **DEMANDE DE BREVET EUROPEEN**

(43) Date de publication:
**03.04.2002 Bulletin 2002/14**

(51) Int Cl.⁷: **H03L 7/197**

(21) Numéro de dépôt: **01203613.3**

(22) Date de dépôt: **24.09.2001**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **29.09.2000 FR 0012459**

(71) Demandeur: **Koninklijke Philips Electronics N.V.**
**5621 BA Eindhoven (NL)**

(72) Inventeurs:
• **Nozahic, Franck, Société Civile S.P.I.D.**
**75008 Paris (FR)**
• **Jovenin, Fabrice, Société Civile S.P.I.D.**
**75008 Paris (FR)**

(74) Mandataire: **Chaffraix, Jean**
**Société Civile S.P.I.D.**
**156, Boulevard Haussmann**
**75008 Paris (FR)**

(54) **Synthétiseur de fréquence et procédé de synthèse de fréquence à faible bruit**

(57) Synthétiseur de fréquence, pourvu d'une boucle à verrouillage de phase (10) comprenant :

- un diviseur de fréquence (14), à rapports de division entiers connecté entre un oscillateur commandé en tension VCO (12) et un comparateur phase-fréquence PFD (16),
- un modulateur sigma-delta (30) connecté au diviseur de fréquence (14) pour commuter le rapport de division du diviseur de fréquence entre une série d'au moins deux valeurs entières, de façon à obtenir un rapport de division moyen résultant à composante fractionnaire, le modulateur présentant au moins une entrée numérique (34, 50) apte à recevoir une consigne de la composante fractionnaire.

Conformément à l'invention, le synthétiseur de fréquences comprend en outre :

- des moyens pour fixer à 1 la valeur du bit de plus faible poids de la consigne d'ajustage.

FIG. 3

EP 1 193 876 A1

**Description**

Domaine technique

La présente invention concerne un synthétiseur de fréquences et un procédé pour la synthèse de fréquences à faible bruit.

Elle concerne plus particulièrement un synthétiseur de fréquences dont la fréquence de sortie peut être ajustée par valeurs entières ou fractionnaires.

Un tel synthétiseur de fréquences peut être utilisé dans différents types de circuits radioélectriques et en particulier dans des étages de réception et/ou d'émission de ces circuits. A titre d'exemple, le synthétiseur de fréquences de l'invention peut être utilisé dans des équipements de téléphonie sans fil, tels que les téléphones portables.

Etat de la technique antérieure

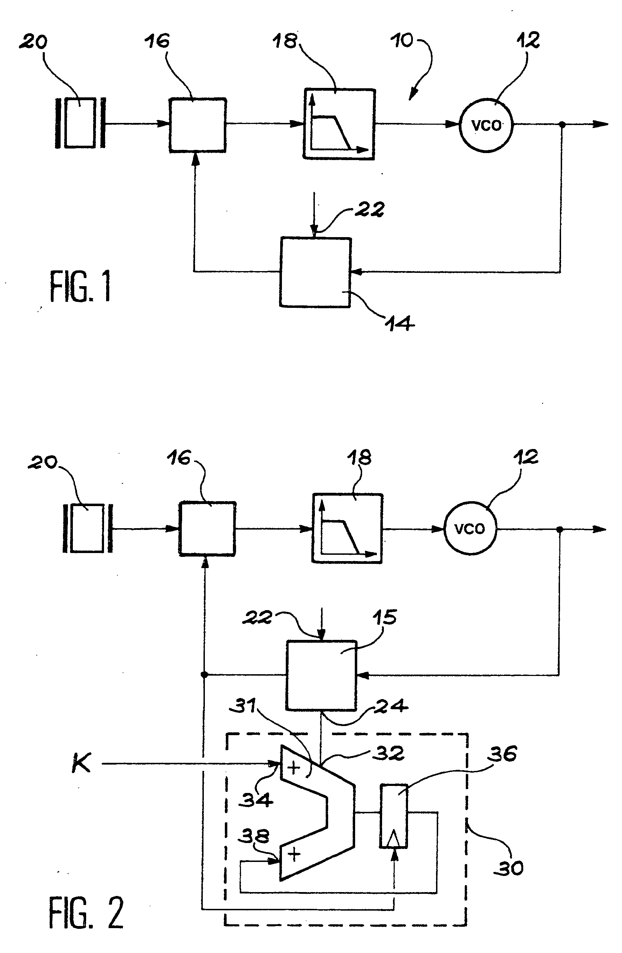

Les figures 1 et 2 annexées illustrent respectivement un synthétiseur de fréquences ajustables par valeurs entières, et un synthétiseur de fréquences ajustables par valeurs fractionnaires. On entend par synthétiseur de fréquences ajustables par valeurs fractionnaires, un synthétiseur de fréquence dont la fréquence peut être ajustée par multiples entiers ou non entiers d'une fréquence de référence. De tels dispositifs sont en soi connus et illustrés, par exemple, par les documents (1), (2) et (3) dont les références complètes sont précisées à la fin de la description.

La figure 1 indique la structure de base d'un synthétiseur de fréquences qui est construit autour d'une boucle à verrouillage de phase 10. La boucle à verrouillage de phase comporte pour l'essentiel un oscillateur commandé en tension 12, un diviseur de fréquence 14, un comparateur phase-fréquence 16 et un filtre passe-bas 18.

L'oscillateur commandé en tension 12, désigné par « oscillateur VCO » dans la suite du texte, délivre un signal de sortie dont la fréquence peut être augmentée ou diminuée en fonction d'une tension de commande appliquée à son entrée. Cette tension de commande est fournie par le comparateur phase-fréquence 16 qui est relié à l'entrée de l'oscillateur VCO 12 par l'intermédiaire du filtre passe bas 18.

Le comparateur phase-fréquence 16 compare la fréquence (ou la phase) d'un signal délivré par le diviseur de fréquence 14 et la fréquence d'un signal de référence délivré, dans l'exemple de la figure, par un dispositif à quartz 20. Lorsque la fréquence du signal délivré par le diviseur de fréquence est inférieure à celle du signal de référence, le comparateur phase-fréquence fournit une tension commandant l'augmentation de la fréquence de l'oscillateur VCO 12. A l'inverse, la fréquence de l'oscillateur VCO est diminuée lorsque la fréquence du signal délivré par le diviseur de fréquences est supérieure à celle du signal de référence.

Le diviseur de fréquence 14 est un dispositif construit autour d'un certain nombre de bascules et ne peut donc diviser la fréquence du signal de l'oscillateur VCO 12 que par des valeurs entières. La rapport de division, ajustable par valeurs entières, est un nombre entier noté N. Une entrée d'ajustage indiquée par une flèche 22 permet de fixer la valeur N.

La fréquence de l'oscillateur VCO, notée $F_{VCO}$ est donc telle que :

$F_{VCO} = N * F_{ref}$, où $F_{ref}$ est la fréquence du signal de référence délivré par le dispositif à quartz **20.**

On observe qu'une modification d'une unité de la valeur du rapport de division N (entier), provoque une variation égale à $F_{ref}$, de la fréquence de l'oscillateur VCO. Ainsi, il n'est pas possible d'ajuster la fréquence de l'oscillateur VCO 12 avec une résolution supérieure à $F_{ref}$. Or, dans la mesure où la fréquence du signal de référence est relativement élevée, cette résolution peut s'avérer très insuffisante.

Un ajustage beaucoup plus fin de la fréquence du signal de sortie de la boucle 10, c'est à dire de la fréquence du signal délivré par l'oscillateur VCO 12, peut être obtenu avec un synthétiseur de fréquences conforme à la figure 2.

Le synthétiseur de fréquences de la figure 2 comprend une boucle à verrouillage de phase 10 avec les mêmes éléments que ceux de la boucle 10 de la figure 1.

Le diviseur de fréquences 14, en revanche, présente non seulement une entrée d'ajustage 22 pour fixer la valeur N du rapport de division, mais également une entrée de commutation 24 pour commuter le rapport de division entre deux ou plusieurs valeurs consécutives autour de la valeur N. Dans l'exemple de la figure 2, l'entrée de commutation 24 du diviseur de fréquence 14 permet de commuter le rapport de division entre deux valeurs qui sont N et N+1.

L'entrée de commutation 24 est reliée à un modulateur sigma-delta 30 et plus précisément à une borne 32 de retenue de dépassement (overflow) de ce modulateur.

Le modulateur sigma-delta 30, qui, dans l'exemple de la figure est un modulateur numérique d'ordre 1 avec un additionneur de mots 31, présente une première entrée numérique 34 pour une consigne d'ajustage notée K. La consigne d'ajustage est additionnée à une valeur numérique délivrée par un registre à décalage 36 du modulateur. Le registre 36 est cadencé par le signal de sortie du diviseur de fréquence 14, et reçoit la sortie de l'additionneur de mots 31. Il est relié à une deuxième entrée numérique 38 de l'additionneur. Lorsque la somme de la consigne d'ajustage et de la sortie du registre 36 est inférieure à la capacité numérique de l'additionneur 31, la retenue de dépassement prend la valeur logique 0, par exemple. En revanche, lorsque la somme est supérieure à la capacité de l'additionneur 31, la retenue prend la valeur logique complémentaire, 1 en l'occurrence.

Le diviseur de fréquence 14 est conçu de façon à effectuer une division de fréquence avec un premier rapport de division lorsque son entrée de commutation 24 reçoit le premier état logique et de façon à effectuer une division avec un deuxième rapport de division, différent de +/-1, lorsque l'entrée 24 reçoit le deuxième état de commutation.

Dans l'exemple décrit le rapport de division est N pour un état logique 1 et est N+1 pour un état logique 0.

Bien qu'à tout instant le rapport de division du diviseur de fréquence soit un nombre entier, la commutation répétée du rapport entre N et N+1, permet d'obtenir un rapport de division moyen résultant compris entre ces deux valeurs, c'est à dire un rapport non entier.

De façon plus précise, on a :

$$Fvco = \frac{1}{T_N + T_{N+1}} \left[ T_N * N * F_{ref} + T_{N+1} * (N + 1) * F_{ref} \right]$$

Soit

$$Fvco = \left[ N + \frac{T_{N+1}}{T_N + T_{N+1}} \right] * F_{ref}$$

Dans ces expressions $T_N$ et $T_{N+1}$ sont respectivement les périodes pendant lesquelles le rapport de division est égal à N et N+1.

En considérant que la consigne d'ajustage K appliquée à la première entrée 34 du modulateur sigma-delta est codée sur L bits, et que la capacité maximum de l'additionneur est de $2^L$-1, on peut définir une partie fractionnaire du rapport de division égale à $K/2^L$. On a :

$$Fvco = \left[ N + \frac{K}{2^L} \right] * F_{ref}$$

Pour des valeurs faibles de la consigne d'ajustage ($K \cong 0$) la fréquence de sortie est voisine de $F_{ref}*(N)$ et pour des valeurs fortes de la consigne d'ajustage ($K \cong 2^L$), la fréquence de sortie est voisine de $F_{ref}*(N+1)$.

Il est ainsi possible d'ajuster continûment la fréquence de la boucle à verrouillage de phase entre deux valeurs fixées par le choix du rapport de division N appliquée à l'entrée d'ajustage 22 du diviseur de fréquence 14 et par le choix de la consigne d'ajustage K appliquée au modulateur sigma-delta.

L'analyse spectrale de la sortie d'un synthétiseur de fréquence utilisant une boucle à verrouillage de phase conforme à la figure 2 montre une distribution de composantes de bruit autour d'une raie centrale correspondant à la fréquence $F_{VCO}$. Le bruit résulte de la contribution des différents organes de la boucle à verrouillage de phase ainsi que du modulateur sigma-delta.

Comme le suggère le document (3), déjà mentionné, il est possible de remplacer le modulateur sigma-delta à un étage tel que représenté à la figure 2, par un modulateur sigma-delta à plusieurs étages en cascade et en particulier par un modulateur sigma-delta à deux étages. Un modulateur sigma-delta à deux étages (d'ordre 2) permet en effet une meilleure mise en forme de la répartition fréquentielle du bruit en reportant au moins une partie du bruit vers des fréquences élevées. Ce phénomène, accentué par la multiplication des étages, est désigné par « noise shaping » (mise en forme du bruit).

Les inventeurs ont en effet mis en évidence une autre manifestation du bruit dans la réponse spectrale du générateur de fréquences qui se traduit par des raies secondaires parasites. Ces raies secondaires apparaissent en particulier pour certaines valeurs de la consigne d'ajustage K.

Exposé de l'invention

Les inventeurs ont en effet constaté que la répétition des valeurs logiques appliquées à l'entrée de commutation du diviseur de fréquences sont à l'origine des raies parasites. La répétition régulière des valeurs logiques selon des motifs courts, par exemple 110011001100 etc., conduit à un petit nombre de raies parasites. L'amplitude de ces raies est cependant importante. Ce phénomène a lieu lorsque la valeur de la consigne d'ajustage K est paire.

Lorsqu'en revanche la valeur de la consigne d'ajustage K est impair, la répétition des motifs reste certes régulière, mais les motifs deviennent très longs. L'énergie du bruit est alors répartie sur un grand nombre de raies parasites de faible amplitude qui s'apparentent à un continuum. L'amplitude des raies prises individuellement est cependant très faible de sorte qu'elles disparaissent dans le bruit des autres organes du synthétiseur de fréquences.

De façon plus précise, la valeur de la fréquence des fréquences parasites peut être donnée par la relation suivante :

$$F_{spur} = \frac{F_{ref} \cdot 2^M}{2^{(0-1)} * 2^L}$$

Dans cette expression $F_{spur}$ indique la fréquence de récurrence des raies parasites et M indique le nombre de fois qu'il est possible de diviser par 2 le nombre K codé sur L bits, et O indique l'ordre du modulateur sigma-delta.

L'invention a pour but de proposer un synthétiseur de fréquences amélioré dont le spectre de réponse en fréquence ne comporte sensiblement pas de raies parasites dépassant un continuum de bruit. Un but est également de proposer un procédé de synthèse de fréquences permettant d'éliminer ces raies parasites.

Pour atteindre ces buts, l'invention a plus précisément pour objet un synthétiseur de fréquence, pourvu d'une boucle à verrouillage de phase comprenant :

- un diviseur de fréquence, à rapports de division entiers, connecté entre un oscillateur VCO (oscillateur commandé en tension) et un comparateur PFD (comparateur phase-fréquence),
- un modulateur sigma-delta connecté au diviseur de fréquence pour commuter le rapport de division du diviseur de fréquence entre une série d'au moins deux valeurs entières, de façon à obtenir un rapport de division moyen résultant à composante fractionnaire, le modulateur présentant une entrée numérique pour une consigne d'ajustage de la composante fractionnaire.

Conformément à l'invention, le synthétiseur de fréquences comprend en outre :

- des moyens pour fixer à 1 la valeur du bit de plus faible poids de la consigne d'ajustage.

Le fait de fixer à 1 la valeur du bit de plus faible poids de la consigne d'ajustage revient à la rendre impaire. Ceci permet de répartir l'énergie de bruit sur un continuum de fréquences. Pour chacune de ces fréquences, prise individuellement, l'amplitude de bruit est par conséquent très faible. En dehors de la fréquence centrale d'oscillation, aucune raie parasite n'apparaît alors sur le spectre de réponse en fréquence.

Selon une réalisation particulière du synthétiseur de fréquences, celui-ci peut comporter un registre d'entrée d'une valeur de commande de la composante fractionnaire, ainsi que des moyens pour remplacer le bit de plus faible poids de la valeur de commande par la valeur 1 et pour appliquer au modulateur cette valeur comme consigne d'ajustage.

Dans ce cas, le bit de plus faible poids de la consigne d'ajustage est arbitrairement fixé à 1 quel que soit la valeur introduite dans le registre d'entrée. Eventuellement, le remplacement du bit de plus faible poids pourrait n'avoir lieu que si celui-ci est différent de 1 (c'est à dire égal à 0).

Selon une autre possibilité, les moyens pour fixer à 1 la valeur du bit de plus faible poids peuvent comporter des moyens pour ajouter un bit, égal à 1, à la valeur de commande de la composante fractionnaire et former ainsi la consigne d'ajustage appliquée à l'entrée de modulateur sigma-delta.

A titre d'exemple, lorsque le synthétiseur de fréquences comprend un registre d'entrée de rang L-1, les moyens pour ajouter un bit égal à 1 peuvent comporter un registre de consigne de rang L, et une bascule verrouillée, pour fixer à 1 le bit de plus faible poids du registre de rang L.

Dans ce cas on remplace une première valeur codée sur L-1 bits par une nouvelle valeur codée sur L bits dont le bit de plus faible poids est égal à 1. Cette dernière valeur est alors utilisée comme consigne d'ajustage.

En toute rigueur, la modification du bit de plus faible poids provoque une modification de la valeur de consigne K souhaitée par l'utilisateur et donc une modification de la fréquence d'oscillation de la boucle de verrouillage de phase. Toutefois l'erreur de la valeur de consigne effectivement fournie au modulateur sigma-delta reste limitée à $1/2^L$ et conduit à un changement de fréquence imperceptible. A titre d'illustration, pour un codage sur 24 bits (L=24) l'erreur est de $1/2^{24}$. ($<10^{-7}$)

Le synthétiseur de fréquence de l'invention peut comporter un modulateur sigma-delta à un seul étage ou un modulateur à plusieurs étages en cascade.

Il ressort de la description qui précède que, pour obtenir un rapport de division moyen avec une composante fractionnaire, on commute le rapport de division du diviseur de fréquence à rapports de division entiers, entre deux ou plusieurs valeurs entières généralement consécutives. Pour un rapport de division moyen de N+k, où k représente la composante fractionnaire et N la composante entière, une commutation peut être faite, par exemple, entre N et N+1.

Or, il s'avère que lorsque N+k est voisin de N ou de N+1, c'est à dire lorsque la composante fractionnaire k est proche de 0 ou de 1, l'une des valeurs de rapport de division entière (N ou N+1) devient largement prépondérante par rapport à l'autre. A titre d'illustration, lorsque k est voisin de 0, c'est à dire lorsque N+k≅N, le rapport de division N est fréquent dans la commutation tandis que le rapport N+1 est rare.

Les inventeurs ont mis en évidence le fait que la répétition élevée d'un même rapport de division entier au détriment d'un ou de plusieurs autres rapports de division entiers raréfiés, conduit également à un bruit qui se manifeste par des raies parasites dans la réponse spectrale du synthétiseur de fréquences.

Pour éviter ce bruit, il est possible, selon un aspect particulier de l'invention, d'équiper le synthétiseur de fréquences d'au moins un diviseur de fréquence à rapport de division fractionnaire fixe, connecté entre l'oscillateur commandé en tension VCO et le diviseur de fréquence à rapports de division entiers. Le synthétiseur de fréquences est alors également équipé de moyens pour activer le diviseur à rapport de division fractionnaire lorsque la composante fractionnaire (k) du rapport de division moyen est contenue dans une ou plusieurs gammes de valeurs déterminées.

Plus précisément, le diviseur de fréquence à rapport de division fractionnaire peut être activé lorsque la composante fractionnaire est voisine de 0 ou de 1 et désactivé dans le cas contraire. Par exemple, les gammes de valeurs de la composantes fractionnaire k, telles que 0<k<0.25 et telles que 0.75<k<1 peuvent correspondre à des gammes d'activation du diviseur de fréquence à rapport de division fractionnaire.

L'activation du diviseur de fréquence à rapport de division fractionnaire, permet avantageusement de modifier la composante fractionnaire du rapport de division moyen qui doit être obtenu par le diviseur de fréquence à rapports de division entiers associé au modulateur sigma-delta.

Pour revenir à l'exemple donné précédemment, lorsque on opère une division supplémentaire par 1.5, ceci revient à ajouter 0.5 à la composante fractionnaire du rapport de division moyen souhaité.

Ainsi en supposant que 0<k<0.25, on a :

$$N+k = N+0.5+k'$$

Dans cette expression, la nouvelle composante fractionnaire k' est telle que

$$0.25 \leq k' \leq 0.75$$

De même, en supposant que 0.75<k<1, on a :

$$N+k = N-1+0.5+k'$$

avec k' telle que 0.25≤k'≤0.75.

En d'autres termes, k', la nouvelle composante fractionnaire qui doit être générée par le diviseur de fréquences à rapports de division entiers associé au modulateur sigma-delta, autorise une alternance plus équilibrée entre les rapports de division , par exemple N et N+1, et évite les raies parasites.

L'invention concerne également un procédé de synthèse à verrouillage de phase au moyen d'un synthétiseur de fréquence comportant :

- un diviseur de fréquence, à rapports de division entiers connecté entre un oscillateur VCO (oscillateur commandé en tension) et un comparateur PFD (comparateur phase-fréquence),
- un modulateur sigma-delta connecté au diviseur de fréquence pour commuter le rapport de division du diviseur de fréquence entre une série d'au moins deux valeurs entières consécutives, de façon à obtenir un rapport de division moyen résultant à composante fractionnaire, le modulateur présentant une entrée numérique pour une consigne d'ajustage de la composante fractionnaire.

Conformément au procédé, on forme une consigne d'ajustage pour le modulateur sigma-delta, par modification d'une valeur d'entrée de commande. La valeur d'entrée est modifiée de façon à la rendre impaire.

SYMBOLSYMBOLSYMBOL Lorsque le synthétiseur de fréquence est équipé d'un diviseur de fréquence à rapport de division fractionnaire fixe, tel qu'indiqué précédemment, on active ledit diviseur de fréquence à rapport de division fractionnaire lorsque la composante fractionnaire (k) du rapport de division moyen est contenue dans au moins une gamme de valeurs déterminée, et on modifie de manière correspondante le consigne d'ajustage de la composante fractionnaire du modulateur sigma delta pour conserver inchangé un rapport de division global fourni par le diviseur de fréquence à rapport de division fractionnaire associé au diviseur de fréquence à rapports de division entiers. Cet aspect de l'invention sera décrit de façon plus détaillée dans la suite du texte.

L'invention concerne également un convertisseur de fréquence comprenant un mélangeur avec une première entrée pouvant être connectée à une source de signal délivrant un signal avec une fréquence à convertir. Le convertisseur comprend par ailleurs une source de signal avec une fréquence de référence, reliée à une deuxième entrée. Conformément à l'invention, la source de signal avec un fréquence de référence peut comporter un synthétiseur de fréquence tel que décrit ci dessus. Un tel convertisseur de fréquence peut notamment être utilisé dans un téléphone portable.

Enfin l'invention concerne un synthétiseur de fréquence, pourvu d'une boucle à verrouillage de phase comprenant :

- un diviseur de fréquence, à rapports de division entiers, connecté entre un oscillateur commandé en tension VCO et un comparateur phase-fréquence PFD,
- un modulateur sigma-delta connecté au diviseur de fréquence pour commuter le rapport de division du diviseur de fréquence entre une série d'au moins deux valeurs entières, de façon à obtenir un rapport de division moyen résultant à composante fractionnaire, le modulateur présentant au moins une entrée numérique apte à recevoir une consigne d'ajustage de la composante fractionnaire, et
- au moins un diviseur de fréquence à rapport de division fractionnaire fixe, connecté entre l'oscillateur commandé en tension VCO et le diviseur de fréquence à rapports de division entiers, et des moyens pour activer le diviseur à rapport de division fractionnaire lorsque la composante fractionnaire (k) du rapport de division moyen est contenue dans au moins une gamme de valeurs déterminée.

D'autres caractéristiques et avantages de l'invention ressortiront de la description qui va suivre, en référence aux figures des dessins annexés. Cette description est donnée à titre purement illustratif et non limitatif.

Brève description des figures.

La figure 1, déjà décrite, est un schéma de principe simplifié d'un synthétiseur de fréquences connu, à ajustage de fréquence discret.

La figure 2, déjà décrite, est un schéma de principe simplifié d'un synthétiseur de fréquences connu, à ajustage de fréquence continu.

La figure 3, est un schéma simplifié d'un synthétiseur de fréquences conforme à l'invention.

La figure 4 est un schéma illustrant une réalisation particulière d'un modulateur sigma-delta pour un synthétiseur de fréquence conforme à la figure 3.

La figure 5 est un schéma simplifié illustrant une possibilité de réalisation perfectionnée d'un synthétiseur de fréquences conforme à l'invention.

La figure 6 est une représentation schématique d'un diviseur de fréquence à rapport de division fractionnaire fixe, utilisé dans le synthétiseur de fréquence de la figure 5.

La figure 7 est un chronogramme illustrant le fonctionnement du diviseur de fréquence à rapport de division fractionnaire fixe de la figure 6.

La figure 8 est un diagramme illustrant la réponse spectrale d'un synthétiseur de fréquences conforme à la figure 2.

La figure 9 est un diagramme illustrant la réponse spectrale d'un synthétiseur de fréquences conçu conformément à l'invention.

La figure 10 est une représentation schématique d'un convertisseur de fréquence utilisant un synthétiseur de fréquence conforme à l'invention.

Description détaillée de modes de mise en oeuvre de l'invention.

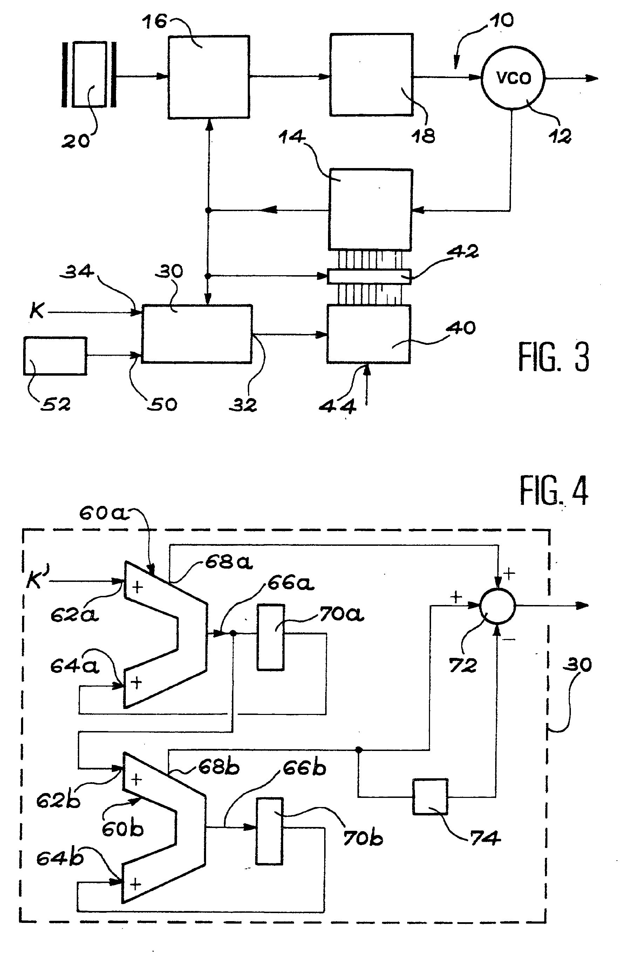

Les éléments des figures 3, 4 et 5 qui sont identiques similaires ou équivalents à des éléments correspondants des figures précédentes sont repérés avec les mêmes références et leur description détaillée n'est pas reprise ici.

La figure 3 montre un synthétiseur de fréquences construit autour d'une boucle à verrouillage de phase 10, comprenant un oscillateur 12 commandé en tension, un diviseur de fréquences 14, un comparateur phase fréquence 16 et un filtre passe-bas 18.

Le diviseur de fréquences 14 est un diviseur programmable capable de diviser la fréquence d'un signal qui lui est appliqué par un nombre entier. Il est associé à un calculateur 40 de rapport de division destiné à commander un rapport de division noté N en fonction d'un signal délivré par un modulateur sigma-delta 30.

Plus précisément, le calculateur 40, piloté par le modulateur sigma-delta, est capable de commander une commutation du rapport de division entre deux ou plusieurs valeurs consécutives (ou non) entières pour obtenir, de façon résultante, un rapport de division moyen à composante fractionnaire.

La référence 42 désigne simplement un registre de synchronisation connecté entre le calculateur 40 et le diviseur de fréquence 14. Ce registre, de même que le modulateur sigma-delta, sont cadencés par le signal de sortie du diviseur de fréquence 14 qui leur est appliqué. La référence 44 désigne une entrée du calculateur 40 prévue pour la sélection d'un canal par l'utilisateur, c'est à dire pour la sélection de la partie entière du rapport de division souhaité.

On peut observer que le modulateur sigma-delta présente deux entrées 34 et 50.

La première entrée 34 est tout à fait comparable à l'entrée numérique du modulateur sigma-delta de la figure 2. Elle est destinée à la transmission au modulateur d'une valeur de commande K de la composante fractionnaire. La première entrée est codée sur un nombre L-1 de bits, égal, par exemple à 22. La valeur de commande K peut être entrée par l'utilisateur ou, le cas échéant, par une autre partie de circuit d'accord non représentée.

La deuxième entrée 50 du modulateur, codée sur un seul bit, est reliée à une bascule 52 verrouillée à la valeur logique 1. La deuxième entrée et la bascule verrouillée 52 sont matérialisées sur la figure pour des raisons de clarté, mais sont en fait intégrées sur une même puce que le modulateur sigma-delta et ne sont pas accessibles à l'utilisateur.

La valeur de commande K appliquée à la première entrée 34 est combinée avec la valeur 1 disponible sur la seconde entrée 50 pour former une nouvelle valeur de consigne d'ajustage K'. Cette nouvelle valeur de consigne K' est codée sur L bits et est formée de la valeur 1 de l'entrée 50 qui constitue le bit de plus faible poids et des L-1 bits de la première entrée 34 qui constituent les bits de plus fort poids.

La nouvelle valeur de consigne K', effectivement utilisée pour le modulateur sigma-delta, est donc nécessairement une valeur de consigne impaire.

D'autres possibilités sont envisageables pour former une valeur de consigne d'ajustage K' impaire. Il est possible, par exemple, de substituer la valeur 1 à la valeur du bit de plus faible poids de la valeur de commande K appliquée à la première entrée 34.

La sortie 32 du modulateur sigma-delta, reliée au calculateur 40 est codée, dans l'exemple illustré, sur deux bits. Toutefois un codage sur un unique bit, comme dans l'exemple de la figure 2 est également envisageable.

La figure 4 décrite ci-après indique une réalisation possible du modulateur sigma-delta 30 de la figure 3 et permet de mieux comprendre le codage sur deux bits de la sortie 32.

Le modulateur sigma-delta de la figure 4 comprend deux étages en cascade, construits chacun autour d'un additionneur de mots. Un premier additionneur de mots 60a présente une première entrée 62a à laquelle on applique la consigne d'ajustage K' qui, conformément à l'invention, a été rendue impaire.

La sortie 66a du premier additionneur de mots 60a est reliée à sa deuxième entrée 64a par l'intermédiaire d'un registre cadencé 70a. Le registre cadencé 70a peut être piloté par exemple par le signal de fréquence divisée délivré par le diviseur de fréquence. Ainsi, à chaque impulsion, la somme obtenue précédemment à la sortie 66a est renvoyée sur la deuxième entrée.

Lorsque la somme est inférieure à la capacité de l'additionneur de mots, celui-ci délivre en sa borne de dépassement 68a une retenue dont la valeur logique est 0. En revanche, lorsque la somme est supérieure à la capacité une valeur logique (retenue) 1 est délivrée. Dans ce cas, seul le reste de l'addition ne dépassant pas la capacité de l'additionneur de mots est délivré sur la sortie 66a.

Finalement, la borne de dépassement 68a délivre une valeur logique codée sur un seul bit, qui peut occuper les états 0 ou 1.

La sortie 66a est également connectée à la première entrée 62b de l'additionneur de mots 60b du second étage. De même, la sortie 66b de cet additionneur est connectée à sa deuxième entrée 64b par un registre cadencé 70b.

L'additionneur de mots 60b du deuxième étage présente également une borne de dépassement 68b dont la sortie logique codée sur deux bits peut occuper les états 0 et 1.

Un additionneur-soustracteur 72 à trois entrées reçoit en entrée positive les valeurs logiques disponibles sur les bornes de dépassement des deux additionneurs de mots 60a, 60b. Il reçoit également, en entrée négative, la retenue de la borne de dépassement de l'additionneur de mots 60b du deuxième étage, par l'intermédiaire d'une bascule de retard 74.

La sortie 76 de l'additionneur-soustracteur est dirigée vers le calculateur 40 de rapport de division évoqué en relation avec la figure 3.

Le tableau I ci après donne a titre indicatif la valeur (décimale) de la sortie de l'additionneur-soustracteur 72 en fonction des valeurs des entrées, et indique le rapport de division correspondant imposé au diviseur 14.

Tableau I

| Additionneur 60a (logique) | Additionneur 60b (logique) | Bascule retard 74 (logique) | Sortie 72 | Division par |
|:---:|:---:|:---:|:---:|:---:|
| 0 | 0 | 1 | -1 | N-1 |
| 0 | 1 | 0 | 1 | N |
| 1 | 0 | 1 | 0 | N+1 |
| 1 | 1 | 0 | 2 | N+2 |

La division successive par les différents rapports de division ci-dessus, dont la séquence est dictée par la consigne d'ajustage K', permet d'obtenir un rapport de division moyen fractionnaire compris entre N et N+1.

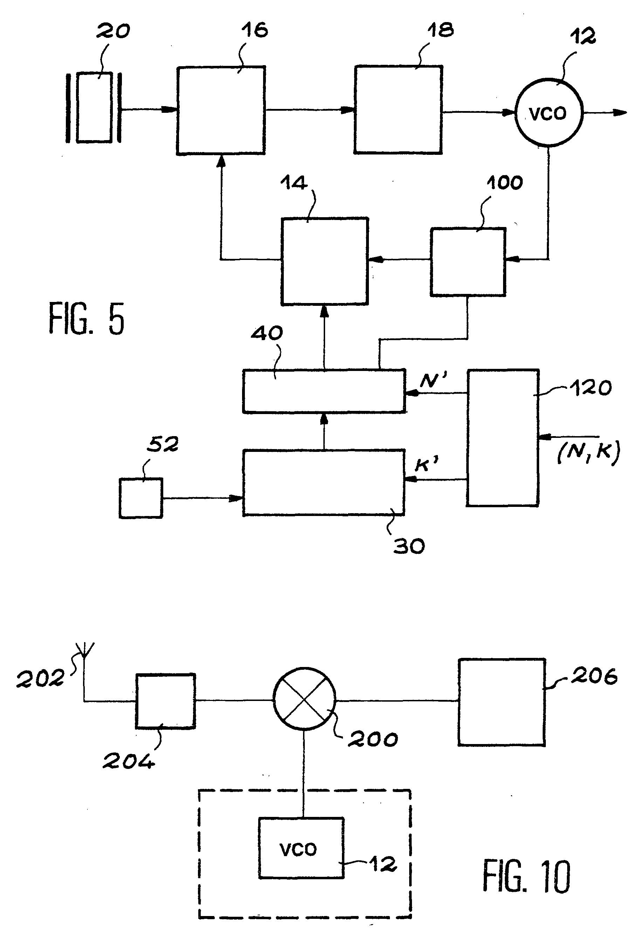

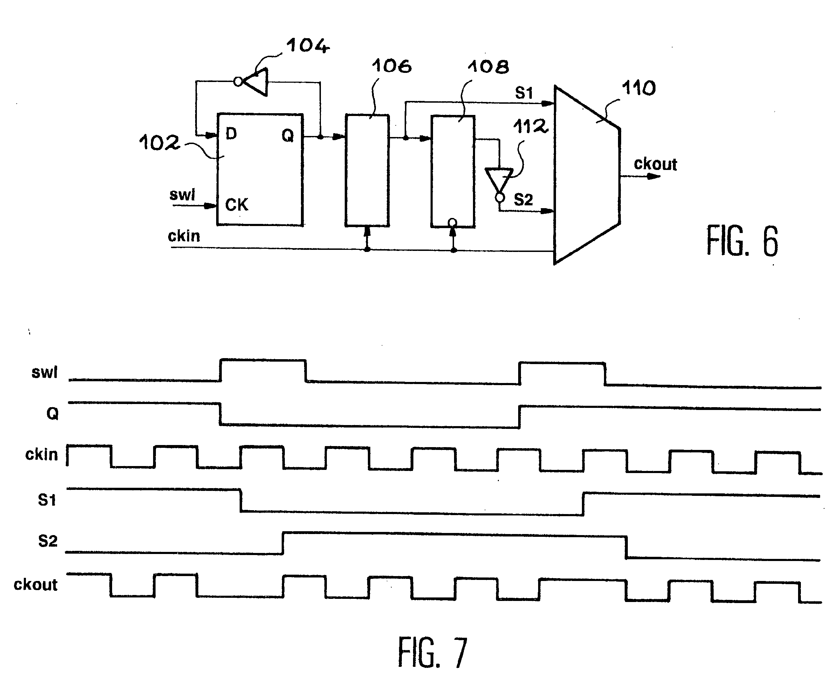

Les figures 5 et 6 examinées ci-après permettent d'illustrer l'amélioration en termes de bruit obtenue grâce à l'invention.

Comme évoqué précédemment, les inventeurs ont établi que les raies parasites du spectre de réponse apparaissent avec une fréquence de récurrence $F_{spur}$ telle que :

$$F_{spur} = F_{ref} / (R * (2^L / 2^M))$$

Dans cette expression R est l'ordre du modulateur sigma-delta c'est à dire le nombre d'étages du modulateur. L est le nombre de bits sur lequel est codé la consigne d'ajustage et M le nombre de fois que La consigne d'ajustage peut être divisée par 2.

A titre d'exemple, pour un rapport de modulation sigma-delta de 0.5, soit pour une consigne K de $2^{22}$, (c'est à dire sans rendre le rapport impair conformément à l'invention), on aurait $M = 2^{22}$. Ainsi, avec une fréquence de référence Fref de 13MHz, on obtiendrait un nombre faible de raies parasites qui se répètent avec une récurrence de 6,25MHz. Ces raies peu nombreuses (tous les 6,25 MHz) ont cependant une forte amplitude qui correspond à l'énergie du bruit.

La figure 5 décrite ci-après indique une autre possibilité de mise en oeuvre de l'invention. Un grand nombre d'éléments de la figure 5 sont identiques à ceux des figures précédemment décrites et sont repérés avec les mêmes références. On peut donc pour ces éléments se reporter à la description qui précède.

A la différence du synthétiseur de la figure 3, le synthétiseur de fréquences de la figure 5 est équipé d'un diviseur de fréquence supplémentaire 100 connecté entre l'oscillateur commandé en tension 12 (VCO) et le diviseur de fréquence 14 à rapports de division entiers. Le diviseur de fréquence supplémentaire 100, est un diviseur de fréquences présentant un rapport de division fractionnaire mais fixe. Dans l'exemple décrit, le rapport de division fixe est de 1.5. Ceci signifie que le diviseur supplémentaire peut soit diviser la fréquence du signal qu'il reçoit par 1.5, lorsqu'il est activé, soit laisser passer le signal inchangé lorsqu'il n'est pas activé. Dans ce cas, la division est en quelque sorte une division par 1. Il convient de préciser que le diviseur 100 peut être remplacé par un diviseur avec un autre rapport fractionnaire ou par une série de deux ou plusieurs diviseurs fractionnaires, connectés à la suite les uns des autres.

La composante fractionnaire k du rapport de division moyen fourni par le diviseur 14 à rapports de division entiers, associé au modulateur sigma-delta, est relié à la consigne d'ajustage K par la relation suivante :

$$K = K/2^L \text{ soit } K = 2^L * k$$

On rappelle que L est le nombre de bits sur lequel est codé la consigne K.

Un étage de circuit ou un calculateur non représentés sont prévus pour établir, en fonction de la fréquence d'oscillation souhaitée, la composante entière N et la composante fractionnaire k du rapport de division moyen. Les valeurs N et k (ou K) sont transmises à un calculateur 120 prévu pour vérifier si k n'est pas trop proche des valeurs 0 ou 1, c'est à dire si K n'est pas trop proche des valeurs 0 ou $2^L$. Dans l'exemple illustré, on considère que k n'est pas trop proche de 0 ou de 1 lorsque la relation suivante est vérifiée

$$0.25 \leq k \leq 0.75$$

Le calculateur 120 est relié au modulateur sigma-delta 30 et au calculateur de rapports de division 40, déjà évoqué en relation avec la figure 3, pour leur transmettre de nouvelles valeurs N' et K' (ou k').

Le tableau II ci-après permet de récapituler les règles d'établissement des valeurs N' et K' en fonction de la valeur de k.

Tableau II

| Valeur de k | Valeur de k' | Valeur de N' | Valeur de K' |
|---|---|---|---|
| 0<k<0.25 | k'=k+0.5 | N'=N-0.5 | K'=2L*k' |
| 0.25≤k≤0.75 | k'= k | N'=N | K'=2L*k' |
| 0.75<k<1 | k'=k-0.5 | N'=N+0.5 | K'=2L*k' |

On peut observer dans le tableau que N' n'est plus nécessairement une valeur entière, tandis que N était entière. Il convient de préciser à ce sujet que, par un jeu de codage binaire, il est possible de ramener l'expression de N' à une valeur numérique codée.

Le calculateur de rapports de division 40 est relié au diviseur 14 à rapports de division entiers, de façon à imposer une succession de rapports de division entiers dépendant du signal reçu par le convertisseur sigma- delta, de la façon décrite précédemment.

Or, comme le convertisseur sigma-delta reçoit la nouvelle consigne d'ajustage, il permet de commander une séquence de rapports de division entiers du diviseur 14 dans lequel aucune répétition excessive d'un rapport de division (entier) n'a lieu.

Les rapports de division entiers alternent, par exemple, entre des valeurs P et P+1 ou encore, dans l'exemple décrit, entre des valeurs P-1, P, P+1 et P+2. On peut à ce sujet se reporter par analogie au tableau I.

Les rapports de division P-1, P, P+1 et P+2 sont établis dans le calculateur 40 en fonction de la sortie du modulateur sigma-delta et en fonction de la partie entière de N' c'est à dire en fonction de N.

Le calculateur de rapports de division 40 pilote également l'activation ou non du diviseur 100 à rapport de division fractionnaire. Dans un cas particulier où N est une valeur numérique (codée par exemple sur 6 bits), le bit de plus faible poids peut être utilisé pour l'activation (ou non) du diviseur de fréquences à rapport de division fractionnaire tandis que les autres bits (de plus fort poids) peuvent être utilisés pour déterminer la valeur de P mentionnée ci-dessus.

Le tableau III ci après, qu'il convient de lire en association avec le tableau II, indique selon la valeur de k, la valeur de P en fonction de N, et l'état d'activation du diviseur 100 à rapport de division fractionnaire.

Tableau III

| Valeur de k | Valeur de N' | Valeur de P | Activation du diviseur 100 |
|---|---|---|---|
| 0<k<0.25 | N-0.5 | P=N-1 | Oui (div. par1.5) |
| 0.25<_k_<0.75 | N | P=N | Non (div. par 1) |
| 0.75<k<1 | N+0.5 | P=N | Oui (div. par1.5) |

Grâce à l'activation du diviseur 100 à rapport de division fractionnaire, il est possible, sans changer le rapport de division global obtenu par les deux diviseurs 14 et 100, c'est à dire sans changer la fréquence de sortie du synthétiseur de fréquence, de parfaire l'élimination de raies parasites de bruit dans sa réponse spectrale.

La figure 6, propose une possibilité particulière de réalisation d'un diviseur à rapport fractionnaire. Il s'agit en l'occurrence d'un diviseur par 1.5 tel qu'évoqué précédemment.

Le diviseur de la figure 6 comprend une bascule D 102, de type connu, avec une entrée D et une sortie Q. Une deuxième entrée reçoit un signal de synchronisation noté swl. La sortie Q de la bascule 102 est reliée d'une part à l'entrée D, par l'intermédiaire d'un inverseur 104, et d'autre part à l'entrée d'une première porte latch 106.

La sortie de la première porte latch 106 est connectée, d'une part, à l'entrée d'une seconde porte latch 108, et d'autre part, à une première entrée S1 d'un multiplexeur 110. La sortie de la deuxième porte latch 108 est reliée à une deuxième entrée S2 du multiplexeur 110 par l'intermédiaire d'un inverseur 112. Les portes latch 106 et 108, de même que le multiplexeur 110 sont cadencés par un signal d'entrée ckin, qui est en l'occurrence le signal à diviser.

Le signal divisé, noté ckout, disponible à la sortie 114 du multiplexeur 110, correspond au signal d'entrée dans lequel certains fronts de transition entre un état haut et un état bas sont éliminés.

Le fonctionnement du diviseur de la figure 6 est précisé par le chronogramme de la figure 7, qui, sur une même base temporelle, indique l'état des entrées et des sorties des composants du diviseur de la figure 6. Le chronogramme indique en particulier le signal de synchronisation swl, le signal de sortie Q, de la bascule D 102, le signal d'entrée ckin à diviser, le signal disponible sur les entrées S1 et S2 du multiplexeur et le signal divisé de sortie ckout. On observe en comparant les signaux ckin et ckout que des fronts de transition sont éliminés de proche en proche, notamment lorsque les entrées S1 et S2 sont dans un même état logique. L'élimination de ces fronts correspond à la division de la fréquence.

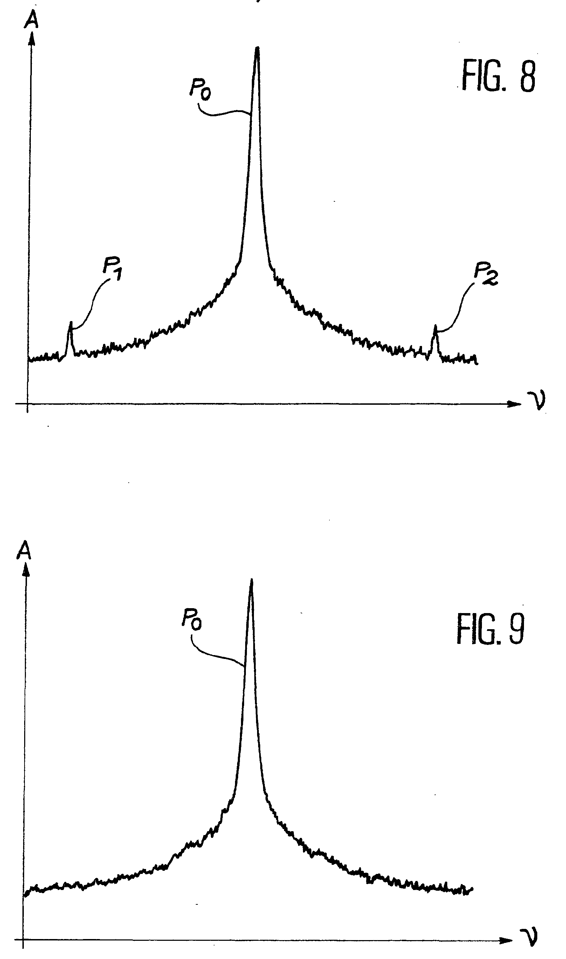

La figure 8 est un diagramme qui représente en fonction de la fréquence v reportée en abscisse, l'amplitude A de la réponse spectrale d'un synthétiseur qui ne met pas en oeuvre l'invention. La figure 8, dont l'échelle est arbitraire, permet de distinguer à côté de la raie principale $P_0$, correspondant à la fréquence d'oscillation de la boucle, des raies parasites $P_1$ et $P_2$.

En revanche, en rendant la consigne K' impaire de la façon décrite précédemment, la fréquence de répétition des raies « parasites » tombe à 0,77Hz. Les raies sont donc très nombreuses et très rapprochées, et l'énergie de bruit se trouve répartie. L'amplitude des raies parasites est donc très faible de sorte que ces raies ne sont plus perceptibles.

Ce résultat apparaît sur la figure 9, qui indique, de façon comparable à la figure 8, la réponse spectrale d'un synthétiseur de fréquences conforme à l'invention. On n'observe plus qu'une seule raie $P_0$ correspondant à la fréquence d'oscillation de la boucle.

La figure 10 montre une application d'un synthétiseur de fréquences conforme à l'invention à la réalisation d'un convertisseur de fréquence et plus précisément à un convertisseur de fréquence dans un émetteur-récepteur de signaux.

Le convertisseur comprend un mélangeur auquel est connecté d'une part une source de signal à convertir, par exemple une antenne 202 associée à un filtre 204, et d'autre part une unité de traitement 206. L'unité de traitement 206 reçoit le signal dont la fréquence est convertie. Il s'agit, par exemple, d'une unité de traitement d'un téléphone portable.

Le mélangeur 200 reçoit également un signal de fréquence de référence qui, dans l'exemple décrit, provient d'un oscillateur VCO 12 d'un synthétiseur de fréquence 1 conforme à l'invention.

Documents cités

(1) EP-B-0 661 816
(2) EP-A-0 563 400
(3) "Fractional-N PII using delta-sigma modulation" de Thomas Stichelbout Aalborg University, August 5, 1997, pages 1 à 21.

**Revendications**

**1.** Synthétiseur de fréquence, pourvu d'une boucle à verrouillage de phase (10) comprenant :

- un diviseur de fréquence (14), à rapports de division entiers, connecté entre un oscillateur commandé en tension VCO (12) et un comparateur phase-fréquence PFD (16),
- un modulateur sigma-delta (30) connecté au diviseur de fréquence (14) pour commuter le rapport de division du diviseur de fréquence entre une série d'au moins deux valeurs entières, de façon à obtenir un rapport de division moyen résultant à composante fractionnaire, le modulateur présentant au moins une entrée numérique (34, 50) apte à recevoir une consigne d'ajustage de la composante fractionnaire,
 **caractérisé en ce qu'**il comprend en outre :
- des moyens pour fixer à 1 la valeur du bit de plus faible poids de la consigne d'ajustage.

**2.** Synthétiseur selon la revendication 1, comprenant une entrée (34) pour une valeur de commande (K) de la composante fractionnaire, et dans lequel les moyens pour fixer à 1 la valeur de bit de plus faible poids comportent des moyens (52) pour ajouter un bit, égal à 1, à la valeur de commande (K) de la composante fractionnaire et former ainsi la consigne d'ajustage (K') appliquée au modulateur sigma-delta.

**3.** Synthétiseur selon la revendication 2, comprenant un registre d'entrée de rang L-1, où L est un entier, et dans lequel les moyens pour ajouter un bit égal à 1 comportent un registre de consigne de rang L, une bascule (52) verrouillée pour fixer à 1 le bit de plus faible poids du registre de rang L et des moyens pour copier la valeur de commande dans le registre de consigne de rang L comme bits de plus fort poids.

**4.** Synthétiseur selon la revendication 1, comprenant un registre d'entrée d'une valeur de commande (K) de la composante fractionnaire, dans lequel les moyens pour fixer à 1 la valeur du bit de plus faible poids de la consigne d'ajustage comportent des moyens pour remplacer le bit de plus faible poids de la valeur de commande par la valeur 1 et pour appliquer au modulateur cette valeur comme consigne d'ajustage.

**5.** Synthétiseur de fréquence selon la revendication 1, dans lequel le modulateur sigma-delta est un modulateur à deux étages.

**6.** Synthétiseur selon la revendication 1, comprenant en outre au moins un diviseur de fréquence (100) à rapport de division fractionnaire fixe, connecté entre l'oscillateur commandé en tension VCO (12) et le diviseur de fréquence (14) à rapports de division entiers, et des moyens (40,102) pour activer le diviseur à rapport de division fractionnaire lorsque la composante fractionnaire (k) du rapport de division moyen est contenue dans au moins une gamme de valeurs déterminée, et pour modifier de manière correspondante la consigne d'ajustage de la composante fractionnaire du modulateur sigma delta pour conserver inchangé un rapport de division global du diviseur de fréquence à rapport de division fractionnaire associé au diviseur de fréquence à rapports de division entiers.

**7.** Synthétiseur selon la revendication 6, dans lequel les gammes de valeurs de la composante fractionnaire k, telles que 0<k<0.25 et que 0.75<k<1 correspondent à des gammes d'activation du diviseur de fréquence (100) à rapport de division fractionnaire.

**8.** Synthétiseur selon la revendication 7, dans lequel le diviseur à rapport de division fractionnaire est un diviseur par 1.5.

**9.** Procédé de synthèse de fréquence au moyen d'un synthétiseur à verrouillage de phase comportant :

- un diviseur de fréquence (14), à rapports de division entiers connecté entre un oscillateur commandé en tension VCO (12) et un comparateur phase-fréquence PFD (16),
- un modulateur sigma-delta (30) connecté au diviseur de fréquence pour commuter le rapport de division du diviseur de fréquence entre une série d'au moins deux valeurs entières, de façon à obtenir un rapport de division moyen résultant à composante fractionnaire, le modulateur présentant une entrée numérique pour une consigne d'ajustage de la composante fractionnaire, et selon lequel on forme une consigne d'ajustage pour modulateur sigma-delta, par modification d'une valeur d'entrée de commande, la valeur d'entrée étant modifiée de façon à la rendre impaire.

**10.** Procédé selon la revendication 9, dans lequel on modifie un bit de plus faible poids de la valeur d'entrée de commande pour le rendre égal à 1.

**11.** Procédé selon la revendication 9, dans lequel on ajoute un bit de plus faible poids, égal à 1, à la valeur d'entrée de commande pour former la consigne d'ajustage.

**12.** Procédé de synthèse de fréquence selon la revendication 9, au moyen d'un synthétiseur de fréquence comprenant en outre au moins un diviseur de fréquence (100) à rapport de division fractionnaire fixe, connecté entre l'oscillateur commandé en tension VCO (12) et le diviseur de fréquence (14) à rapports de division entiers, dans lequel on active ledit diviseur de fréquence à rapport de division fractionnaire lorsque la composante fractionnaire (k) du rapport de division est contenue dans au moins une gamme de valeurs déterminée et on modifie de manière correspondante la consigne d'ajustage de la composante fractionnaire du modulateur sigma delta pour conserver inchangé un rapport de division global du diviseur de fréquence à rapport de division fractionnaire associé au diviseur de fréquence à rapports de division entiers.

**13.** Procédé selon la revendication 12, dans lequel on active ledit diviseur de fréquence à rapport de division fractionnaire lorsque la composante fractionnaire k du rapport de division est telle que 0<k<0.25 ou que 0.75<k<1, et on désactive ledit diviseur de fréquence à rapport de division fractionnaire lorsque la composante fractionnaire k du rapport de division est telle que 0.25≤k≤0.75.

**14.** Convertisseur de fréquence comprenant un mélangeur (200) avec une première entrée connectée à une source de signal délivrant un signal avec une fréquence à convertir, et comprenant une source de signal (1) avec une fréquence de référence reliée à une deuxième entrée du mélangeur, **caractérisé en ce que** la source de signal (1) avec une fréquence de référence comprend un synthétiseur de fréquence conforme à l'une quelconque des revendications précédentes.

**15.** Utilisation d'un convertisseur de fréquences selon la revendication 14 dans un téléphone portable.

FIG. 1

FIG. 2

FIG. 3

FIG. 4

FIG. 5

FIG. 10

FIG. 6

FIG. 7

FIG. 8

FIG. 9

**Office européen des brevets**

## RAPPORT DE RECHERCHE EUROPEENNE

Numéro de la demande

EP 01 20 3613

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | LIZHONG SUN ET AL.: "Reduced Complexity, High Performance Digital Delta-Sigma Modulator for Fractional-N Frequency Synthesis" PROCEEDINGS OF THE 1999 IEEE INTERNATIONAL SYMPOSIUM ON CIRCUITS AND SYSTEMS, 1999, 'en ligne! vol. 2, 30 mai 1999 (1999-05-30), pages 152-155, XP002168214 ISBN: 0-7803-5471-0 * page 152, colonne 1 * * page 153, colonne 1, ligne 23 - page 154, colonne 2, ligne 15; figures 1,3,5-7 * | 1-5, 9-11,14, 15 | H03L7/197 |
| A | US 5 867 068 A (KEATING PIERCE V) 2 février 1999 (1999-02-02) * colonne 4, ligne 19 - colonne 8, ligne 40; figures 1,4,5,7-10,13-16 * | 6-8,12, 13 | |
| X | SHPERLING I: "SIGMA DELTA MODULATOR WITH A RANDOM OUTPUT BIT STREAM OF SPECIFIED 1/0 AVERAGE RATIO" MOTOROLA TECHNICAL DEVELOPMENTS,US,MOTOROLA INC. SCHAUMBURG, ILLINOIS, vol. 18, 1 mars 1993 (1993-03-01), pages 156-160, XP000349609 * page 156 * * figures * | 1,4,5,9, 10,14,15 | **DOMAINES TECHNIQUES RECHERCHES (Int.Cl.7)** H03L |
| X | US 5 055 802 A (HIETALA ALEXANDER W ET AL) 8 octobre 1991 (1991-10-08) * colonne 6, ligne 32 - colonne 8, ligne 22 * * colonne 11, ligne 21 - ligne 57 * * figures 8-12 * | 1,4,5,9, 10,14,15 | |

-/--

Le présent rapport a été établi pour toutes les revendications

| Lieu de la recherche | Date d'achèvement de la recherche | Examinateur |
|---|---|---|
| LA HAYE | 11 janvier 2002 | Balbinot, H |

Office européen
des brevets

**RAPPORT DE RECHERCHE EUROPEENNE**

Numéro de la demande

EP 01 20 3613

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 070 310 A (HIETALA ALEXANDER W ET AL) 3 décembre 1991 (1991-12-03) <br> * colonne 6, ligne 53 - colonne 8, ligne 13 * <br> * colonne 13, ligne 23 - ligne 59 * <br> * figures 5,6 * <br> ----- | 1,4,5,9, 10,14,15 | |
| | | | **DOMAINES TECHNIQUES RECHERCHES (Int.Cl.7)** |

Le présent rapport a été établi pour toutes les revendications

| Lieu de la recherche | Date d'achèvement de la recherche | Examinateur |
|---|---|---|
| LA HAYE | 11 janvier 2002 | Balbinot, H |

CATEGORIE DES DOCUMENTS CITES

X : particulièrement pertinent à lui seul
Y : particulièrement pertinent en combinaison avec un autre document de la même catégorie
A : arrière–plan technologique
O : divulgation non–écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

# EP 1 193 876 A1

## ANNEXE AU RAPPORT DE RECHERCHE EUROPEENNE
## RELATIF A LA DEMANDE DE BREVET EUROPEEN NO.

EP 01 20 3613

11-01-2002

| Document brevet cité au rapport de recherche | | Date de publication | Membre(s) de la famille de brevet(s) | | Date de publication |
|---|---|---|---|---|---|
| US 5867068 | A | 02-02-1999 | AU | 1114799 A | 17-05-1999 |
| | | | WO | 9922449 A1 | 06-05-1999 |
| US 5055802 | A | 08-10-1991 | AU | 631993 B2 | 10-12-1992 |
| | | | AU | 7797091 A | 27-11-1991 |
| | | | BR | 9105749 A | 19-05-1992 |
| | | | CA | 2048645 A1 | 31-10-1991 |
| | | | DE | 69121040 D1 | 29-08-1996 |
| | | | DE | 69121040 T2 | 20-02-1997 |
| | | | EP | 0480012 A1 | 15-04-1992 |
| | | | JP | 2756728 B2 | 25-05-1998 |
| | | | JP | 5500894 T | 18-02-1993 |
| | | | MX | 172915 B | 20-01-1994 |
| | | | SG | 46287 A1 | 20-02-1998 |
| | | | WO | 9117604 A1 | 14-11-1991 |
| US 5070310 | A | 03-12-1991 | AT | 402247 B | 25-03-1997 |
| | | | AT | 900691 A | 15-07-1996 |
| | | | AU | 632243 B2 | 17-12-1992 |
| | | | AU | 8395591 A | 30-03-1992 |
| | | | BR | 9105891 A | 13-10-1992 |
| | | | CA | 2066745 A1 | 01-03-1992 |
| | | | DE | 4192081 C2 | 01-02-1996 |
| | | | DE | 4192081 T | 27-08-1992 |
| | | | DK | 54892 A | 28-04-1992 |
| | | | ES | 2088714 A1 | 16-08-1996 |
| | | | FI | 921960 A | 30-04-1992 |
| | | | FR | 2666464 A1 | 06-03-1992 |
| | | | GB | 2255680 A ,B | 11-11-1992 |
| | | | HK | 32497 A | 27-03-1997 |
| | | | IE | 913059 A1 | 11-03-1992 |
| | | | IT | 1250771 B | 21-04-1995 |
| | | | JP | 2844389 B2 | 06-01-1999 |
| | | | JP | 5502154 T | 15-04-1993 |
| | | | KR | 9601074 B1 | 18-01-1996 |
| | | | MX | 9100853 A1 | 01-04-1992 |
| | | | SE | 469579 B | 26-07-1993 |
| | | | SE | 9201350 A | 22-06-1992 |
| | | | WO | 9204766 A1 | 19-03-1992 |

EPO FORM P0460